# FASCICULE DE BREVET EUROPEEN

(11) **EP 1 076 365 B1**
(45) Date de publication et mention de la délivrance du brevet: **05.07.2006**
(21) Numéro de dépôt: 00410094.7
(22) Date de dépôt: 08.08.2000
(51) Int. Cl.: H01L 29/747

(54) **Commutateur statique bidirectionnel sensible**
Empfindlicher statischer Zweirichtungsschalter
Sensitive static bidirectional switch

(30) Priorité: 09.08.1999 FR 9910412
(43) Date de publication de la demande: 14.02.2001
(73) Titulaire: STMicroelectronics S.A., 92120 Montrouge (FR)
(72) Inventeur: Duclos, Franck, 37000 Tours (FR); Simonnet, Jean-Michel, 37270 Veretz (FR); Ladiray, Olivier, 37270 Montlouis sur Loire (FR)
(74) Mandataire: de Beaumont, Michel

(56) Documents cités:
- EP-A- 0 817 277
- US-A- 4 157 562

## Description

La présente invention concerne la réalisation sous forme monolithique de commutateurs bidirectionnels de moyenne puissance.

Les commutateurs bidirectionnels statiques les plus courants sont les triacs. Un triac correspond à l'association en antiparallèle de deux thyristors. Il peut donc être connecté directement dans un réseau alternatif, par exemple le secteur. La gâchette d'un triac classique correspond à la gâchette de cathode de l'un au moins des deux thyristors qui le constituent et est référencée à l'électrode située sur la face avant de ce triac, c'est-à-dire la face qui comporte la borne de gâchette, alors que c'est l'autre face du triac qui est couramment reliée à un radiateur et à la masse.

On considérera ci-après plus particulièrement des commutateurs bidirectionnels du type décrit dans la demande de brevet européen N° 0817277 dont le déclenchement est assuré par application d'une tension entre une électrode de commande située sur la face avant du composant et une électrode principale située sur la face opposée du composant.

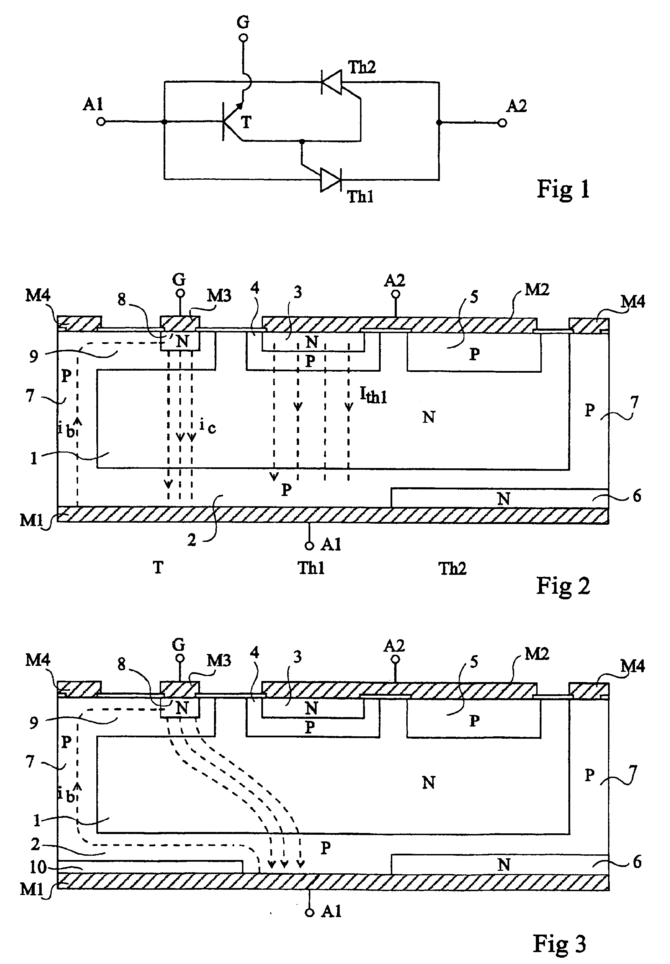

La figure 1 représente un schéma électrique équivalent d'un tel commutateur bidirectionnel. Une électrode G de commande du commutateur bidirectionnel est reliée à l'émetteur d'un transistor bipolaire T dont le collecteur est relié aux gâchettes d'anode de premier et deuxième thyristors Th1 et Th2 placés en antiparallèle entre deux bornes A1 et A2. La borne A1 correspond à l'anode du thyristor Th1 et à la cathode du thyristor Th2. La borne A1 est également reliée à la base du transistor T. La borne A2 correspond à l'anode du thyristor Th2 et à la cathode du thyristor Th1.

La figure 2 est une vue en coupe schématique d'un exemple de réalisation sous forme monolithique du commutateur bidirectionnel décrit en relation avec la figure 1. Le transistor T est réalisé dans la partie gauche de la figure, le thyristor Th1 au centre et le thyristor Th2 à droite.

La structure de la figure 2 est formée à partir d'un substrat semiconducteur 1 faiblement dopé de type N. L'anode du thyristor Th1 correspond à une couche 2 de type P qui est formée du côté de la face arrière du substrat 1. Sa cathode correspond à une région 3 de type N formée du côté de la face avant dans un caisson 4 de type P. L'anode du thyristor Th2 correspond à un caisson 5 de type P formé du côté de la face avant et sa cathode correspond à une région 6 de type N formée du côté de la face arrière dans la couche 2. La périphérie de la structure est constituée d'une région 7 de type P fortement dopée s'étendant depuis la face avant jusqu'à la couche 2 de type P. De façon classique, la région 7 est obtenue par diffusion profonde à partir des deux faces du substrat. La face arrière est revêtue d'une métallisation M1 correspondant à la première borne A1 du commutateur bidirectionnel. Les faces supérieures des régions 3 et 5 sont revêtues d'une deuxième métallisation M2 correspondant à la deuxième borne A2 du commutateur bidirectionnel. Une région 8 de type N est formée, du côté de la face avant, dans un caisson 9 de type P en contact avec la région périphérique 7. La surface de la région 8 est solidaire d'une métallisation M3 reliée à la borne de commande G du commutateur bidirectionnel. Une métallisation M4 peut être formée sur la surface supérieure de la région périphérique 7. La métallisation M4 n'est pas connectée à une borne externe. A titre de variante, le caisson 9 peut être séparé de la région périphérique 7 et relié électriquement à celle-ci par l'intermédiaire de la métallisation M4.

Le fonctionnement de ce commutateur bidirectionnel est le suivant.

Quand la borne A2 est négative par rapport à la borne A1, c'est le thyristor Th1 qui est susceptible d'être passant. Si on applique sur la borne G une tension suffisamment négative par rapport à la métallisation M1, la jonction base-émetteur du transistor T est polarisée en direct et ce transistor devient passant. Il circule donc un courant vertical i_{C} représenté en pointillés en figure 2 depuis la métallisation M1, à travers la jonction en direct entre la couche 2 et le substrat 1 puis dans les régions 1, 9 et 8 correspondant au transistor T. Il y a donc une génération de porteurs au niveau de la jonction entre le substrat 1 et le caisson 9 près de la jonction entre le substrat 1 et le caisson 4 et le thyristor Th1 est mis en état de conduction. On peut également considérer que l'on a provoqué l'amorçage d'un thyristor auxiliaire vertical NPNP comprenant les régions 8-9-1-2, dont la région 9 constitue la région de gâchette de cathode.

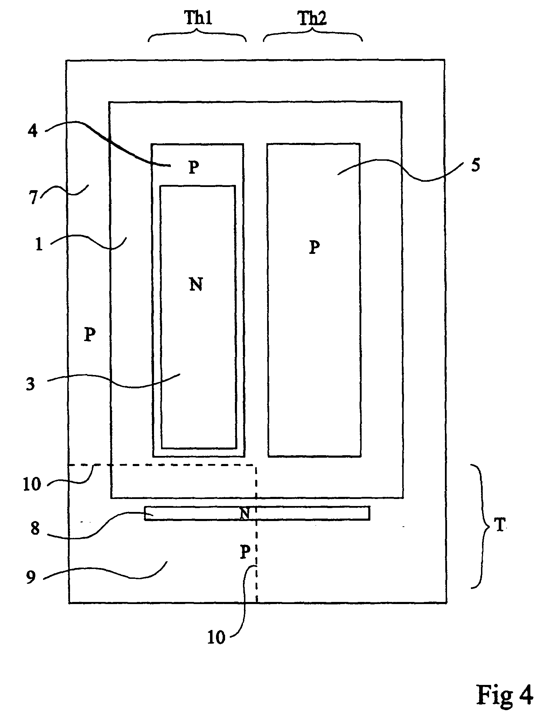

De même, dans le cas où la borne A2 est positive par rapport à la borne A1, l'application d'une tension négative sur la borne G rend passant le transistor T. Les porteurs présent au voisinage de la jonction entre le substrat 1 et la couche 2 entraînent la mise en conduction du thyristor Th2 comme on le comprendra mieux en se référant à la vue de dessus schématique de la figure 4 dans laquelle on voit que la région correspondant au transistor T est voisine d'une portion de chacun des thyristors Th1 et Th2.

L'expérience montre que ce type de commutateur bidirectionnel présente une sensibilité de commande non optimale, c'est-à-dire, notamment que le courant nécessaire à l'amorçage du thyristor Th1 est de plusieurs centaines de milliampères.

Un objet de la présente invention est de proposer un nouveau mode de réalisation sous forme monolithique d'un commutateur bidirectionnel du type susmentionné qui présente une plus grande sensibilité de commande du thyristor Th1.

Pour atteindre cet objet, la présente invention prévoit un commutateur bidirectionnel monolithique selon la revendication 1.

Selon un mode de réalisation de la présente invention, la région supplémentaire est en un matériau semiconducteur du premier type de conductivité.

Selon un mode de réalisation de la présente invention, l'épaisseur de la région supplémentaire est inférieure à celle de la couche de face arrière du deuxième thyristor vertical principal.

Selon un mode de réalisation de la présente invention, la région supplémentaire est en oxyde de silicium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma électrique d'un commutateur bidirectionnel classique ;
la figure 2 est une vue en coupe schématique d'un mode de réalisation classique du commutateur bidirectionnel de la figure 1 ;
la figure 3 représente une vue en coupe schématique d'un mode de réalisation selon la présente invention du commutateur bidirectionnel de la figure 1 ; et
la figure 4 représente un exemple de vue de dessus du commutateur bidirectionnel de la figure 3.

Par souci de clarté, les mêmes éléments ont été désignés par les mêmes références aux différentes figures. De plus, comme cela est habituel dans la représentation des circuits intégrés, les figures 2, 3 et 4 ne sont pas tracées à l'échelle.

La figure 3 est une vue en coupe schématique d'un mode de réalisation d'un commutateur bidirectionnel monolithique selon la présente invention. La structure des diverses zones formées dans le substrat semiconducteur 1 est identique à celle -illustrée en figure 2. La différence entre les deux figures est qu'il est prévu du côté de la face arrière, entre la couche 2 et la métallisation M1, une région 10 ayant une fonction d'isolement, sensiblement au droit du thyristor auxiliaire vertical susmentionné. Ceci ressort également de la figure 4 dans laquelle le contour de la région 10 est désigné par un trait en pointillés à la partie inférieure gauche de la figure. La couche 6, non représentée en figure 4, occupe toute la face inférieure à l'exception de la zone située sous le caisson 4 de type P et de la surface occupée par la région 10.

Selon un mode de réalisation de la présente invention, la région 10 est en un matériau semiconducteur dopé de type N.

Le fonctionnement du commutateur bidirectionnel reste sensiblement similaire à ce qui a été décrit en relation avec la figure 2. Toutefois, le courant de base i_{b} du transistor T, allant de la métallisation M1 vers la région 8 est maintenant dévié par la présence de la région 10, selon le trajet i_{b} de la figure 3.

Le courant principal du thyristor auxiliaire vertical est également dévié, comme le montrent les flèches i_{c}. On voit qu'en modifiant les dimensions de la région 10, on favorise le passage du courant i_{c} au voisinage des zones où il est le plus efficace pour provoquer l'amorçage du thyristor Th1, c'est-à-dire près de la limite du caisson 4.

Les essais effectués par la demanderesse ont montré que le courant d'amorçage du thyristor Th1 est minimisé lorsque la région 10 s'étend jusqu'à être en regard du caisson 4 de type P dans lequel est formée la région 3 de type N constituant la cathode du thyristor Th1.

Selon la présente invention, l'épaisseur de la région 10 doit être suffisamment faible pour permettre initialement l'amorçage du transistor T par le passage du courant i_{b} de la couche 2 vers la région 8 par l'intermédiaire de la région périphérique 7. En effet, si la région 10 est trop épaisse, l'épaisseur restante de la couche 2 entre cette région 10 et le substrat 1 entraîne l'existence d'une trop forte résistance qui s'oppose à la circulation du courant de base i_{b}.

En pratique, l'épaisseur de la région 10 sera inférieure à celle de la couche 6. En effet, la couche 6 constitue la cathode du thyristor Th2 et son épaisseur est fixée par les caractéristiques, notamment de courant d'amorçage de ce seul thyristor. L'épaisseur de la couche 6 sera par exemple de l'ordre de 10 à 15 µm, alors que l'épaisseur de la région 10 sera aussi faible que possible.

Selon une variante de réalisation de la présente invention, la région 10 est en un matériau isolant, de préférence en oxyde de silicium (SiO₂).

Bien entendu, la présente invention est susceptible de diverses variantes et modifications qui apparaîtront à l'homme de l'art dans les limites définies par les revendications. En particulier, dans ces limites, la présente invention s'applique à tout type de réalisation sous forme monolithique de la structure de commutateur bidirectionnel ou d'un réseau de commutateurs bidirectionnels similaires à celui représenté en figure 1. En outre, tous les types de conductivité pourraient être inversés, les polarisations étant alors modifiées de façon correspondante.

## Revendications

1. Commutateur bidirectionnel monolithique formé dans un substrat semiconducteur (1) d'un premier type de conductivité ayant une face avant et une face arrière, comprenant :
un premier thyristor vertical principal (Th1) ayant une couche de face arrière (2) du deuxième type de conductivité et une couche de face avant (3) du premier type de conductivité,
un deuxième thyristor vertical principal (Th2) ayant une couche de face arrière (6) du premier type de conductivité et une couche de face avant (5) du deuxième type de conductivité,
un thyristor vertical auxiliaire ayant une couche de face arrière (2) du deuxième type de conductivité commune avec la couche de face arrière du premier thyristor,
une région périphérique (7) du deuxième type de conductivité en contact avec la couche de face arrière du thyristor auxiliaire et avec une couche intermédiaire (9) du deuxième type de conductivité de ce thyristor située du côté de la face avant du substrat (1),
une première métallisation (M1) du côté de la face arrière reliant les couches de face arrière (2, 6) des premier et deuxième thyristors,
une deuxième métallisation (M2) du côté de la face avant reliant les couches de face avant (3, 5) des premier et deuxième thyristors,
**caractérisé en ce qu'**il comporte une région supplémentaisre (10) ayant une fonction d'isolement entre la couche de face arrière du thyristor auxiliaire et la première métallisation (M1).

2. Commutateur bidirectionnel selon la revendication 1, **caractérisé en ce que** la région supplémentaire (10) est en un matériau semiconducteur du premier type de conductivité.

3. Commutateur bidirectionnel selon la revendication 2, **caractérisé en ce que** l'épaisseur de la région supplémentaire (10) est inférieure à celle de la couche de face arrière (6) du deuxième thyristor vertical principal (Th2).

4. Commutateur bidirectionnel selon la revendication 1, **caractérisé en ce que** la région supplémentaire (10) est en oxyde de silicium.

## Claims

1. A monolithic bidirectional switch formed in a semiconductor substrate (1) of a first conductivity type having a front surface and a rear surface, including:
a first main vertical thyristor (Th1), having a rear surface layer (2) of the second conductivity type, and a front surface layer (3) of the first conductivity type,
a second main vertical thyristor (Th2), having a rear surface layer (6) of the first conductivity type, and a front surface layer (5) of the second conductivity type,
an auxiliary vertical thyristor (Th2), having a rear surface layer (2) of the second conductivity type common with the rear surface layer of the first thyristor,
a peripheral region (7) of the second conductivity type in contact with the rear surface layer of the auxiliary thyristor and with an intermediate layer (9) of this thyristor located on the front surface of the substrate (1),
a first metallization (M1) on the rear surface side connecting the rear surface layers (2, 6) of the first and second thyristors,
a second metallization (M2) on the front surface side connecting the front surface layers (3, 5) of the first and second thyristors,
**characterized in that** it comprises an additional region (10) having a function of isolation between the rear surface layer of the auxiliary thyristor and the first metallization (M1).

2. The bidirectional switch of claim 1, **characterized in that** the additional region (10) is made of a semiconductor material of the first conductivity type.

3. The bidirectional switch of claim 2, **characterized in that** the thickness of the additional region (10) is smaller than that of the rear surface layer (6) of the second main vertical thyristor (Th2).

4. The bidirectional switch of claim 1, **characterized in that** the additional region (10) is made of silicon oxide.

## Patentansprüche

1. Monolithischer bidirektionaler Schalter in Ausbildung in einem Halbleitersubstrat (1) eines ersten Leitfähgkeitstyps, mit einer Vorder-bzw Oberseite und einer Rück-bzw. Unterseite, der Schalter umfassend:
einen ersten vertikalen Hauptthyristor (Th1) mit einer Schicht (2) vom zweiten Leitfähigkeitstyp an der Rückseite und einer Schicht (3) vom ersten Leitfähigkeitstyp an der Vorderseite,
einen zweiten vertikalen Haupttransistor (Th2) mit einer Schicht (6) vom ersten Leitfähigkeitstyp an der Rückseite und einer Schicht (5) vom zweiten Leitfähigkeitstyp an der Vorderseite,
einen vertikalen Hilfsthyristor, welcher eine mit der Rückseitenschicht des ersten Transistors gemeinsame Schicht (2) vom zweiten Leitfähigkeitstyp an der Rückseite aufweist,
einen Umfangsbereich (7) vom zweiten Leitfähigkeitstyp in Kontakt mit der Rückseitenschicht des Hilfsthyristors und mit einer auf der Vorderseite des Substrats (1) gelegenen Zwischenschicht (9) dieses Thyristors vom zweiten Leitfähigkeifstyp,
eine die Rückseitenschichten (2, 6) des ersten und des zweiten Thyristors miteinander verbindende erste Metallisierung (M1) auf der Rückseite,
eine die Vorderseitenschten (3, 5) des ersten und des zweiten Thyristors mit-einander verbindende zweite Metallisierung (M2) auf der Vorderseite,
**dadurch gekennzeichnet, dass** der Schalter einen zusätzlichen Bereich (10) mit der Funktion der Isolierung zwischen der Rückseitenschicht des Hilfsthyristors und der ersten Metallisierung (M1) umfasst.

2. Bidirektionaler Schalter nach Anspruch 1, **dadurch gekennzeichnet, dass** der zusätzliche Bereich (10) aus einem Halb leitermaterial vom ersten Leitfähigkeitstyp besteht.

3. Bidirektionaler Schalter nach Anspruch 2, **dadurch gekennzeichnet, dass** die Dicke des zusätzlichen Bereichs (10) kleiner als die der Rückseitenschicht (6) des zweiten vertikalen Hauptthyristors (Th2) ist.

4. Bidirektionaler Schalter nach Anspruch 1, **dadurch gekennzeichnet, dass** der zusätzliche Bereich (10) aus einem Siliziumoxyd besteht.
